# EUROPEAN PATENT APPLICATION

(11) **EP 4 726 853 A1**
(43) Date of publication of application: **15.04.2026**
(21) Application number: 25203924.3
(22) Date of filing: 23.09.2025
(51) Int. Cl.: H01M 10/42, H01M 10/48

(54) **SYSTEMS AND METHODS FOR DETECTING THERMAL RUNAWAY**

(30) Priority: 08.10.2024 KR 20240137044
(71) Applicant: SAMSUNG SDI CO., LTD., Yongin-si, Gyeonggi-do 17084 (KR)
(72) Inventor: KANG, Taehyeon, 17084 Yongin-Si (KR)
(74) Representative: Marks & Clerk LLP

(57) **Abstract**

The present disclosure relates to a thermal runaway detection method and a thermal runaway detection device and battery system performing the same. An embodiment provides a thermal runaway detection device including: a measuring device configured to measure a temperature of a battery; and a control device configured to monitor the temperature of the battery based on a measurement value received from the measuring device, the control device being further configured to determine that a thermal runaway event has occurred in the battery based on the temperature of the battery and a status of the measuring device satisfying one or more conditions.

## Description

### BACKGROUND

### 1. Field

One or more embodiments of the present disclosure relate to systems and methods for detecting thermal runaway.

### 2. Description of the Related Art

A rechargeable battery is a battery that may be charged and discharged, unlike a primary battery that may not be rechargeable. Low-capacity rechargeable batteries are used in portable small electronic devices such as smartphones, feature phones, laptop computers, digital cameras, and camcorders, and large-capacity rechargeable batteries are widely used as motor driving power and power storage devices such as hybrid vehicles and electric vehicles. The rechargeable battery includes an electrode assembly including a positive electrode and a negative electrode, a case accommodating the electrode assembly, and an electrode terminal connected to the electrode assembly.

In general, the rechargeable battery includes an electrode assembly including a positive electrode, a negative electrode, and a separator interposed between the positive and negative electrodes; a case accommodating the electrode assembly; and an electrode terminal electrically connected to the electrode assembly. An electrolyte solution is injected into the case to enable charging and discharging of the battery through an electrochemical reaction between the positive electrode, the negative electrode, and the electrolyte solution. A shape of the case, such as a cylindrical or rectangular shape, depends on the purpose of the battery.

Lithium-ion batteries, which are representative rechargeable batteries, may cause thermal runaway due to abnormal operating conditions such as internal short circuits, overcharging, high-temperature environments, and deformation caused by external impacts. Thermal runaway may occur when a large amount of heat accumulates inside the battery, causing a chain reaction that may cause the battery to ignite and lead to an explosion. Therefore, quickly detecting thermal runaway of the battery and preventing thermal runaway propagation may be important for providing battery safety.

The above information disclosed in this background section is only for enhancement of understanding of the background of the disclosure, and therefore it may contain information that does not form the prior art that is already known in this country to a person of ordinary skill in the art.

### SUMMARY

Embodiments of the present disclosure provide a thermal runaway detection method that may detect (e.g., quickly detect) thermal runaway in a battery and lessen or prevent its propagation, and a thermal runaway detection device and battery system for performing the same.

However, the technical problem to be solved by the present disclosure is not limited to the above, and other objects not mentioned herein will be understood from the following description by those skilled in the art.

An aspect of the present disclosure provides a thermal runaway detection device including: a measuring device configured to measure a temperature of a battery; and a control device configured to monitor the temperature of the battery based on a measurement value received from the measuring device, the control device being further configured to determine that a thermal runaway event has occurred in the battery based on the temperature of the battery and a status of the measuring device satisfying set conditions.

The conditions may include a first condition including a rate of temperature increase of the battery being at or above a threshold value for at least a first time, and a second condition including the status of the measuring device indicating abnormal operation of the measuring device continuing for at least a second time. The threshold value may be 7°C/s or more. The first time may be 0.5 seconds or more. The second time may be 4 seconds or more.

The control device may be further configured to determine that a thermal runaway event has occurred in the battery based on the second condition being satisfied within a third time after the first condition is satisfied. The third time may be 8 seconds or more.

The control device may be further configured to determine that the status of the measuring device is abnormal based on the measuring device failing to output the measurement value for at least a threshold amount of time.

The control device may be configured to receive a signal indicating the status of the measuring device, and determine the status of the measuring device based on the signal.

The control device may be further configured to notify a protection device configured to protect the battery from thermal runaway of the detection of the thermal runaway event based on detecting the thermal runaway event.

The protection device may include a fire monitoring device configured to spray a fire extinguishing agent onto the battery.

The protection device may include a connection control device configured to block connection between the battery and a load.

Another aspect of the present disclosure provides a battery system including: a battery, and the thermal runaway detection device including at least one of the features described above.

Another aspect of the present disclosure provides a thermal runaway detection method including: monitoring status of a measuring device configured to measure a temperature of a battery; determining whether the temperature of the battery satisfies a first condition; determining whether the status of the measuring device satisfies a second condition; and detecting a thermal runaway event of the battery based on the temperature of the battery satisfying the first condition and the status of the measuring device satisfying the second condition.

The first condition may include rate of a temperature increase of the battery being at or above a threshold value for at least a first time. The second condition may may include the status of the measuring device that indicates abnormal operation of the measuring device continuing for at least a second time.

The detecting may include detecting the thermal runaway event based on the second condition being satisfied within a third time after the first condition is satisfied.

The monitoring may include determining that the status of the measuring device is abnormal based on the measuring device failing to output a measurement value for at least a threshold amount of time.

The monitoring may include receiving a signal indicating the status of the measuring device, and determining the status of the measuring device based on the signal.

The thermal runaway detection method may further include notifying the detection of the thermal runaway event to a fire monitoring device configured to spray a fire extinguishing agent onto the battery based on the thermal runaway event being detected.

The thermal runaway detection method may further include notifying the detection of the thermal runaway event to a connection control device configured to control connection between the battery and a load based on the thermal runaway event being detected.

According to the present disclosure, thermal runaway of a battery may be detected (e.g., quickly detected) and thermal runaway may be lessened or prevented from propagating.

However, effects obtainable through the present disclosure are not limited to the above, and other effects not mentioned herein will be clearly understood by those skilled in the art from the following disclosure.

### BRIEF DESCRIPTION OF THE DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 schematically illustrates a thermal runaway detection device and battery system performing the same according to an embodiment of the present disclosure.
FIG. 2 schematically illustrates a flowchart of a thermal runaway detection method according to an embodiment of the present disclosure.

### DETAILED DESCRIPTION

Hereinafter, embodiments of the present disclosure will be described in detail with reference to the accompanying drawings. Prior to description, it should be understood that terms and words used in the specification and the appended claims should not be limited to common and dictionary meanings, but should be interpreted to encompass meanings and concepts corresponding to technical ideas of the present disclosure in view of the principle that an inventor can be his own lexicographer to properly define the concepts of the terms and words in order to describe his/her own invention as best as possible.

The embodiments described in the specification and the configurations shown in the drawings are some of the embodiments and configurations of the present disclosure, and they do not represent all of the technical ideas of the present disclosure, and it should be understood that there may be various equivalents and modified examples, which may replace the embodiments, are possible when filing the present application.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "comprise, include," "comprising," and/or "including," when used in this specification, specify the presence of the stated features, integers, steps, operations, elements, and/or components but do not preclude the presence or addition of one or more other features, integers, steps, operations, elements, components, and/or groups thereof. The use of "can/may" in describing an embodiment of the present disclosure may include "one or more embodiments of the present disclosure."

In addition, in order to help understanding of the present disclosure, the accompanying drawings are not drawn to scale, and the dimensions of some components may be exaggerated. In addition, the same reference numerals may be assigned to the same elements in different embodiments.

When it is explained that two objects are 'identical' or "the same", this means that these objects are 'substantially identical' or "substantially the same." In some embodiments, the substantially identical objects or substantially the same objects may include deviations considered low in the art, for example, deviations within 5 %. In addition, when it is explained that certain parameters are uniform in a predetermined region, this may mean that the parameters are uniform in terms of an average in the corresponding region.

Although the terms "first", "second", and the like are used to describe various constituent elements, these constituent elements are not limited by these terms. These terms are used to distinguish one element from another, and unless stated to the contrary, a first element may be a second element.

Throughout the specification, unless stated otherwise, each element may be singular or plural.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

When an element is "above (or under)" or "on (or below)" another element, the element can be on an upper surface (or a lower surface) of the other element, and intervening elements may be present between the element and the other element on (or below) the element.

In addition, when an element is referred to as being "connected", "coupled" or "linked" to another element, the element can be directly connected, coupled, or linked to the other element, but it should be understood that intervening elements may be present between each element, or each element may be "connected", "coupled" or "linked" to each other through another element. When one element is referred to as being coupled (e.g., electrically coupled or connected) to another element, the one element may be directly coupled to the another element or indirectly coupled to the another element via one or more intervening elements.

Throughout the specification, unless stated otherwise, "A and/or B" refers to A, B, or A and B. In other words, the term "and/or" includes all or various combinations of a plurality of items that are related and arranged. "C to D" refers to C or greater and D or smaller, unless stated otherwise.

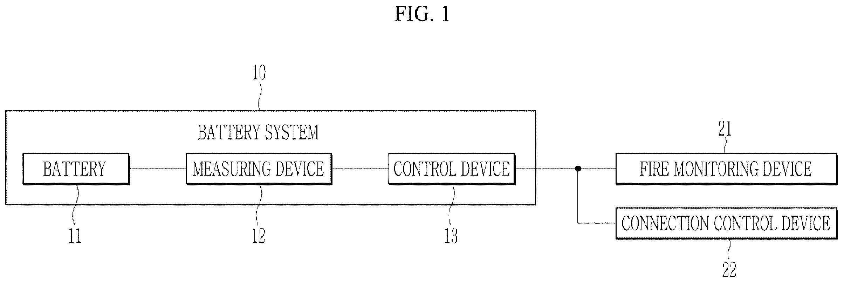

FIG. 1 schematically illustrates a battery system according to an embodiment of the present disclosure.

Referring to FIG. 1, a battery system 10 may include a battery 11, a measuring device 12, and a control device 13.

The battery 11 may include at least one battery cell (not shown). For example, the battery 11 may include a plurality of battery cells connected in series and/or in parallel to each other.

The measuring device 12 may measure a status of the battery 11. For example, the measuring device 12 may measure a voltage, a current, a temperature, a pressure, and the like of the battery 11.

The control device 13 may receive measurement values (for example, a temperature measurement value, a voltage measurement value, a current measurement value, a pressure measurement value, and the like) from the measuring device 12.

The control device 13 may monitor the status of the battery 11 based on the received measurement values. For example, the control device 13 may detect an overvoltage status, an overcurrent status, an overtemperature status, a full discharge status, and a full charge status of the battery 11 based on the received measurement values.

The control device 13 may also detect whether the measuring device 12 is operating normally. The control device 13 may determine the operating status of the measuring device 12 by monitoring whether the measuring device 12 normally outputs measurement values (e.g., outputs the measurement values according to a normal or regular pattern or schedule). For example, the control device 13 may determine that the operating status of the measuring device 12 is abnormal if the measuring device 12 outputs abnormal measurement values for a threshold amount of time (e.g., at least a predetermined time) or does not or fails to output measurement values for a threshold amount of time (e.g., at least a predetermined time). The operation status may be determined to be normal otherwise.

The control device 13 receives a signal (referred to as a monitoring or watchdog signal) from the measuring device 12, and may determine the operating status of the measuring device 12 based on the reception status of the watchdog signal (voltage level, whether the signal is received, pulse width, reception cycle, and the like). For example, the measuring device 12 may output a high-level (or low-level) watchdog signal during normal operation, and may output a low-level (or high-level) watchdog signal during abnormal operation. A high-level signal may include a signal measurement value of 1. A low-level signal may include a signal measurement value of 0. In some embodiments, a normal measurement value includes the signal measurement vlue of 1, and an abnormal measurement value includes the signal measurement value of 0, or vice versa.

The control device 13 may also receive a status signal indicating whether the control device 13 is operating normally from a separate diagnostic device (not shown) that diagnoses the operating status of the measuring device 12. In this case, the battery system 10 may further include a diagnostic device that diagnoses the operating status of the measuring device 12.

The control device 13 may also operate as a thermal runaway detection device together with the measuring device 12.

If thermal runaway of the battery 11 occurs, the measuring device 12 may malfunction or be damaged due to the high temperature of the battery 11. If the measuring device 12 malfunctions or is damaged, the measurement values may not be transmitted to the control device 13 or the transmission may be delayed, which may delay the detection of thermal runaway and result in a dangerous situation in which thermal runaway propagates.

In some embodiments, the control device 13 may detect the thermal runaway event of the battery 11 by monitoring the operating status of the measuring device 12 together with the temperature measurement value measured by the measuring device 12.

If the measuring device 12 operates normally and the temperature measurement value is normally received (e.g., received according to a normal or regular pattern or schedule), the control device 13 may determine whether the temperature of the battery 11 satisfies a first condition based on the received temperature measurement value. The control device 13 may determine that the temperature of the battery 11 satisfies the first condition if the temperature increase rate of the battery 11 is greater than or equal to a threshold value (for example, 7°C/s or more) for at least a threshold or predetermined time (for example, 0.5 seconds or more). In this regard, the first condition is satisfied when the rate of temperature increase is equal or greater than a threshold rate for at least a threshold amount of time.

In some embodiments, if the control device 13 determines that the temperature of the battery 11 satisfies the first condition, the control device 13 may determine whether the operating status of the measuring device 12 satisfies a second condition. In some embodiments, the determining of the operating status of the measuring device need not happen after determining the temperature of the battery 11, and may happen concurrently with, or even before the determining of the temperature of the battery. In either embodiment, if the measuring device 12 maintains an operating status indicative of abnormal operation of the measuring device for at least a threshold or predetermined time (for example, 4 seconds or more), the control device 13 may determine that the operating status of the measuring device 12 satisfies the second condition.

If both the first condition and the second condition are satisfied, the control device 13 may determine that a thermal runaway event has occurred in the battery 11.

In some embodiments, the temperature of the battery 11 may satisfy the first condition or the operating status of the measuring device 12 may satisfy the second condition for reasons other than thermal runaway of the battery 11. In some embodiments, in order to prevent false detection of thermal runaway, the control device 13 may determine that thermal runaway has occurred if the second condition is satisfied within a threshold or predetermined time (for example, 8 seconds) after the first condition is satisfied.

The control device 13 may also perform a communication function with an external device (for example, a fire monitoring device 21, a connection control device 22, an upper control device (not shown), and the like). The control device 13 may transmit the status monitoring results of the battery 11 to the external device, or may receive a control command from the external device.

If the thermal runaway status of the battery 11 is detected, the control device 13 may notify protection devices such as the fire monitoring device 21 and/or the connection control device 22 of the thermal runaway detection, to perform a protection operation to lessen or prevent the thermal runaway propagation. For example, the control device 13 may transmit a notification signal indicating the detection of a thermal runaway event to the fire monitoring device 21 and/or the connection control device 22.

If the fire monitoring device 21 receives a signal notifying the detection of thermal runaway from the control device 13, it may spray an extinguishing agent on the battery 11 to prevent or lesson thermal runaway propagation.

When a signal for notifying the detection of thermal runaway is received from the control device 13, the connection control device 22 opens the blocking device (for example, relay or contactor) connected between the battery 11 and the external device (for example, load or charging device),for blocking the electrical connection between the battery 11 and the external device (for example, load or charging device).

The control device 13 may include at least one processor for performing the above-described functions of the control device 13. The processor may include a data processing device having a physically structured circuit to perform a function expressed by code or instructions included in a program and stored in memory. The data processing device may include a microprocessor, a central processing unit (CPU), a processor core, a multiprocessor, an application-specific integrated circuit (ASIC), a field programmable gate array (FPGA), and the like.

The measuring device 12 may be implemented by an analog front end (AFE) integrated circuit (IC). For example, the functions of the aforementioned measuring device 12 can be performed by the AFE IC.

The control device 13 may be implemented by a battery management system (BMS). For example, the functions of the control device 13 described above may be performed by the BMS.

FIG. 1 illustrates an example in which the connection control device 22 exists separately to block the electrical connection between the battery 11 and the external device. However, in some embodiments, the control device 13 may directly control a blocking device connected between the battery 11 and the external device (for example, a load or a charging device), for blocking the electrical connection between the battery 11 and the external device.

Although the components depicted in FIG. 1 including the battery system 10, fire monitoring device 21, and connection control device 22 are assumed to be separate functional units, a person of skill in the art will recognize that the functionality of the components may be combined or integrated into a single component, or further subdivided into further sub-components without departing from the scope of the inventive concept.

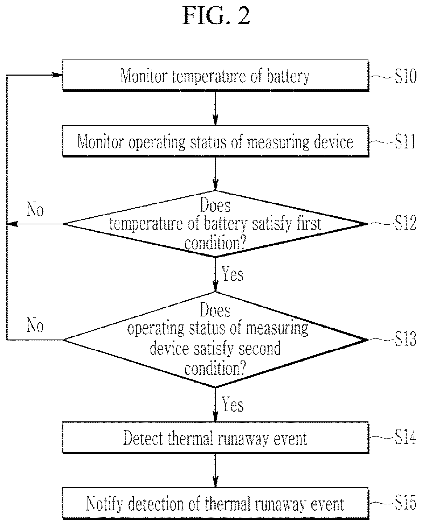

FIG. 2 schematically illustrates a thermal runaway detection method according to an embodiment. The method of FIG. 2 may be performed by the control device 13 in the battery system 10 described with reference to FIG. 1.

Referring to FIG. 2, the control device 13 may monitor the temperature of the battery 11 based on the temperature measurement value of the battery 11 measured by the measuring device 12 (S10).

The control device 13 may monitor the operating status of the measuring device 12 (S11). In some embodiments, the control device 13 may, in operation S11, determine the operating status of the measuring device 12 by monitoring the output measurement values of the measuring device. In some embodiments, the control device 13 in operation S11 may determine the operating status of the measuring device 12 based on a monitoring or watchdog signal received from the measuring device 12 or a status signal received from a separate diagnostic device (not shown) that diagnoses the operating status of the measuring device 12.

The control device 13 may monitor the measurement values received from the measuring device 12 to determine whether the temperature of the battery 11 satisfies the first condition described above (S12). In some embodiments, the control device 13 may determine, in operation S12, that the temperature of the battery 11 satisfies the first condition if the temperature increase rate of the battery 11 is greater than or equal to a set threshold value (for example, 7°C/s or more) for at least a threshold or predetermined (e.g., first) time (for example, 0.5 seconds or more).

If it is determined that the temperature of the battery 11 satisfies the first condition, the control device 13 may additionally determine whether the operating status of the measuring device 12 satisfies the second condition described above (S13). In some embodiments, if the measuring device 12 maintains a type (e.g., an abnormal) operating status for at least a threshold or predetermined (e.g., second) time (for example, 4 seconds or more), the control device 13 may determine, in operation S13, that the operating status of the measuring device 12 satisfies the second condition.

If the second condition is satisfied (e.g., satisfied following the first condition), the control device 13 may detect a thermal runaway event of the battery 11 (S14). If the control device 13 determines that a thermal runaway event has occurred, it may notify the protection device (the fire monitoring device 21 or the connection control device 22) of the detection of the thermal runaway event so that a protective action (such as spraying a fire extinguishing agent, disconnecting the battery, or the like) is performed to lessen or prevent thermal runaway propagation (S15).

The fire monitoring device 21 that is notified of the detection of thermal runaway from the control device 13 may spray a fire extinguishing agent on the battery 11. The connection control device 22 that is notified of the detection of thermal runaway from the control device 13 may open a blocking device (for example, a relay, a contactor, or the like) connected between the battery 11 and an external device (for example, a load or a charging device).

In some embodiments, although not shown in FIG. 1, in order to prevent false detection of thermal runaway, the control device 13 may determine that thermal runaway has occurred if the second condition is satisfied within a predetermined (e.g., third) time (for example, 8 seconds) after the first condition is satisfied.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

### Description of symbols

10: battery system
11: battery
12: measuring device
13: control device
21: fire monitoring device
22: connection control device

## Claims

1. A thermal runaway detection device comprising:
a measuring device configured to measure a temperature of a battery; and
a control device configured to monitor the temperature of the battery based on a measurement value received from the measuring device, the control device being further configured to determine that a thermal runaway event has occurred in the battery based on the temperature of the battery and a status of the measuring device satisfying one or more conditions.

2. The thermal runaway detection device as claimed in claim 1, wherein the one or more conditions include a first condition including a rate of temperature increase of the battery being at or above a threshold value for at least a first time, and a second condition including the status of the measuring device indicating abnormal operation of the measuring device continuing for at least a second time.

3. The thermal runaway detection device as claimed in claim 2, wherein the threshold value is 7°C/s or more,
the first time is 0.5 seconds or more, and
the second time is 4 seconds or more.

4. The thermal runaway detection device as claimed in claim 2 or claim 3, wherein
the control device is further configured to determine that a thermal runaway event has occurred in the battery based on the second condition being satisfied within a third time after the first condition is satisfied;
wherein, optionally, the third time is 8 seconds or more.

5. The thermal runaway detection device as claimed in any preceding claim, wherein
the control device is further configured to determine that the status of the measuring device is abnormal based on the measuring device failing to output the measurement value for at least a threshold amount of time.

6. The thermal runaway detection device as claimed in any preceding claim, wherein the control device is further configured to:
receive a signal indicating the status of the measuring device; and
determine the status of the measuring device based on the signal.

7. The thermal runaway detection device as claimed in any preceding claim, wherein the control device is further configured to notify a protection device configured to protect the battery from thermal runaway, of the detection of the thermal runaway event, based on detecting the thermal runaway event.

8. The thermal runaway detection device as claimed in claim 7, wherein the protection device includes a fire monitoring device configured to spray a fire extinguishing agent onto the battery; and/or
the protection device includes a connection control device configured to block connection between the battery and a load.

9. A battery system comprising:
a battery, and
the thermal runaway detection device according to any preceding claim.

10. A thermal runaway detection method comprising:
monitoring status of a measuring device configured to measure a temperature of a battery;
determining whether the temperature of the battery satisfies a first condition;
determining whether the status of the measuring device satisfies a second condition; and
detecting a thermal runaway event of the battery based on the temperature of the battery satisfying the first condition and the status of the measuring device satisfying the second condition.

11. The thermal runaway detection method as claimed in claim 10, wherein
the first condition includes a rate of temperature increase of the battery being at or above a threshold value for at least a first time, and
the second condition includes the status of the measuring device that indicates abnormal operation of the measuring device continuing for at least a second time.

12. The thermal runaway detection method as claimed in claim 11, wherein
the detecting includes detecting the thermal runaway event based on the second condition being satisfied within a third time after the first condition is satisfied.

13. The thermal runaway detection method as claimed in any one of claims 10 - 12, wherein
the monitoring includes determining that the status of the measuring device is abnormal based on the measuring device failing to output a measurement value for at least a threshold amount of time.

14. The thermal runaway detection method as claimed in any one of claims 10 - 13, wherein the monitoring includes:
receiving a signal indicating the status of the measuring device; and
determining the status of the measuring device based on the signal.

15. The thermal runaway detection method as claimed in any one of claims 10 - 14, further comprising:
notifying the detection of the thermal runaway event to a fire monitoring device configured to spray a fire extinguishing agent onto the battery based on the thermal runaway event being detected; and/or
notifying the detection of the thermal runaway event to a connection control device configured to control connection between the battery and a load based on the thermal runaway event being detected.
